# EUROPEAN PATENT APPLICATION

(11) **EP 4 095 532 A1**
(43) Date of publication of application: **30.11.2022**
(21) Application number: 20914909.5
(22) Date of filing: 14.12.2020
(51) Int. Cl.: G01R 22/06

(54) **MEASUREMENT DEVICE**

(30) Priority: 23.01.2020 JP 2020009546
(71) Applicant: Panasonic Intellectual Property Management Co., Ltd., Osaka-shi, Osaka 540-6207 (JP)
(72) Inventor: NAGANO, Yuichiro, Osaka 540-6207 (JP); KITADE, Keita, Osaka 540-6207 (JP)
(74) Representative: Appelt, Christian W.
(86) International application number: PCT/JP2020/046562
(87) International publication number: WO 2021/149399

(57) **Abstract**

An object of the present disclosure is to provide a measurement device, which can realize reducing influence by noise generated in circuit. A measurement device (10) includes a measuring unit (40), a communications unit (50), a power supply unit (60) and a housing (20). The measuring unit (40) is configured to generate measuring information relating to a prescribed physical quantity based on sensing information from a sensor (300). The communications unit (50) is configured to transmit the measuring information generated by the measuring unit (40). The power supply unit (60) is configured to supply electric power to the measuring unit (40) and the communications unit (50). The housing (20) has a front surface (20a) and a rear surface (20b). The housing (20) houses the measuring unit (40), the communications unit (50) and the power supply unit (60). The measuring unit (40) includes a measuring board (41). The communications unit (50) includes a communications board (51), provided separately from the measuring board (41). The power supply unit (60) includes a power supply board (61) and is provided separately from the measuring board (41) and the communications board (51).

## Description

### Technical Field

The present disclosure generally relates to measurement devices, and more particularly relates to a measurement device to be disposed in a distribution board.

### Background Art

Patent Literature 1 discloses, as one type of electric apparatus, a power measurement unit (measurement device). The power measurement unit of Patent Literature 1 is disposed at a prescribed position in a distribution board and has a function of measuring electric power in each of circuits where sensor units (sensors) are disposed. The power measurement unit is connected to the sensor units with signal lines and electric wires. The power measurement unit outputs a power measurement value to an external monitoring device such as a personal computer through a communications line.

### Citation List

### Patent Literature

Patent Literature 1: JP 2014-199209 A

### Summary of Invention

It is therefore an object of the present disclosure to provide a measurement device, which can realize reducing influence by noise generated in circuit.

A measurement device according to an aspect of the present disclosure includes a measuring unit, a communications unit, a power supply unit and a housing. The measuring unit is configured to generate measuring information relating to a prescribed physical quantity based on sensing information from a sensor. The communications unit is configured to transmit the measuring information generated by the measuring unit. The power supply unit is configured to supply electric power to the measuring unit and the communications unit. The housing has a first surface and a second surface in a prescribed direction. The housing is configured to house the measuring unit, the communications unit and the power supply unit. The measuring unit includes a measuring board. The communications unit includes a communications board, provided separately from the measuring board. The power supply unit includes a power supply board, provided separately from the measuring board and the communications board.

### Brief Description of Drawings

FIG. 1 is a schematic diagram of a distribution board where a measurement device (electric apparatus) according to an exemplary embodiment is installed;
FIG. 2 is a perspective view of the measurement device;
FIG. 3 is another perspective view of the measurement device;
FIG. 4 is another perspective view of the measurement device, where a hiding member is removed from a main body;
FIG. 5 is a cross-sectional view of the measurement device;
FIG. 6 is another cross-sectional view of the measurement device;
FIG. 7 is an exploded perspective view of the measurement device;
FIG. 8 is an exploded perspective view of a circuit section of the measurement device;
FIG. 9 is another exploded perspective view of the circuit section of the measurement device;
FIG. 10 is an explanatory drawing for an assembling method of the measurement device;
FIG. 11 is another explanatory drawing for the assembling method of the measurement device;
FIG. 12 is another explanatory drawing for the assembling method of the measurement device; and
FIG. 13 is another explanatory drawing for the assembling method of the measurement device.

### Description of Embodiments

### (1) Embodiment

### (1-1) Overview

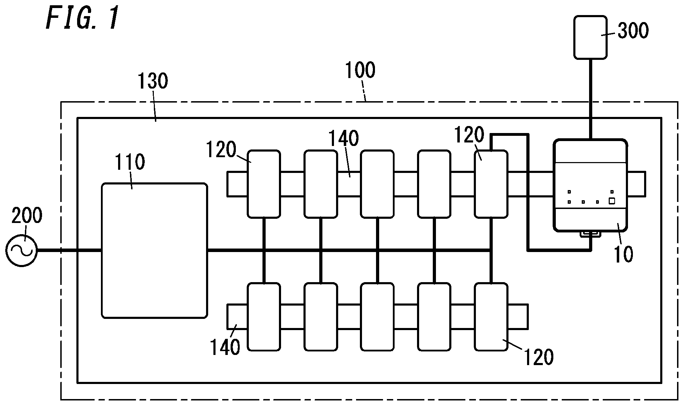

The present embodiment relates to a measurement device (measurement unit), as one type of electric apparatus. FIG. 1 shows a distribution board 100 to which a measurement device 10 according to an exemplary embodiment is applied. The distribution board 100 is provided to distribute electric power received from an AC power supply 200 that is an external power supply. That is to say, the distribution board 100 is electrically connected to the AC power supply 200. The AC power supply is a commercial power supply, as one example. In the example of FIG. 1, the distribution board 100 includes a main open/close device (main breaker) 110 and two or more branch open/close devices (branch breakers) 120. It is not necessary that the distribution board 100 includes the two or more branch open/close devices 120. The distribution board 100 may include one or more branch open/close devices 120. The distribution board 100 further includes a cabinet 130 configured to house therein the main open/close device 110 and the two or more branch open/close devices 120. The cabinet 130 is attached to a construction material (e.g., a wall of a building). The construction material is not limited to a wall of a room in a building (such as a detached house, a dwelling unit of a multiple dwelling house or a tenant building) but may be a ceiling or a floor of the room, for example.

The main open/close device 110 includes a primary terminal, a secondary terminal and a contact connected to an electric path between the primary terminal and the secondary terminal. The main open/close device 110 switches the contact to an open state to shut off the electric path, when detecting an abnormal condition where an overcurrent (such as a leakage current or an overload current) flows to the contact. The main open/close device 110 may have a conventionally known configuration, and detailed explanations thereof will be therefore omitted herein.

The branch open/close devices 120 are breakers for wiring. Each branch open/close device 120 includes a power supply terminal part (primary connecting part) and a load connecting part (secondary connecting part). Each branch open/close device 120 further includes a cutoff circuit. The cutoff circuit includes: a contact device inserted in an electric path between the power supply terminal part and the load connecting part; and an operational handle for operating the contact device. The power supply terminal part is provided for connection to a power supply. Also, the power supply terminal part is provided for electrically connection to the main open/close device 110. The load connecting part is provided for connection to a load. Examples of the load include a wiring device to be provided for connection to an electric apparatus. Examples of the wiring device include an outlet, a hanging ceiling unit and so on. The branch open/close devices 120 each may include a thermal tripping device. The thermal tripping device includes a thermal element (such as a bi-metal or a tri-metal) and is configured to open the contact device of the cutoff circuit by the thermal element being operated. Alternatively, the branch open/close devices 120 each may include an electromagnetic tripping device. The electromagnetic tripping device includes, for example, an electromagnet device, and is configured to instantaneously open the contact device of the cutoff circuit by the electromagnet device being operated. The branch open/close devices 120 may have no function as breakers for wiring. That is to say, the branch open/close devices 120 may be implemented as, for example, switches, relay devices or parallel-off devices.

The cabinet 130 includes two or more attachment members 140. The attachment members 140 are provided for fixing the branch open/close devices 120 to the cabinet 130. In the present embodiment, the attachment members 140 are DIN rails.

The measurement device 10 of the present embodiment is installed in the distribution board 100. The measurement device 10 is attached to an attachment member 140, thereby being fixed to the cabinet 130. The measurement device 10 is electrically connected to a branch open/close device 120 in the distribution board 100 to receive the electric power from the AC power supply 200. Furthermore, the measurement device 10 is electrically connected to the sensor 300 to acquire sensing information from the sensor 300.

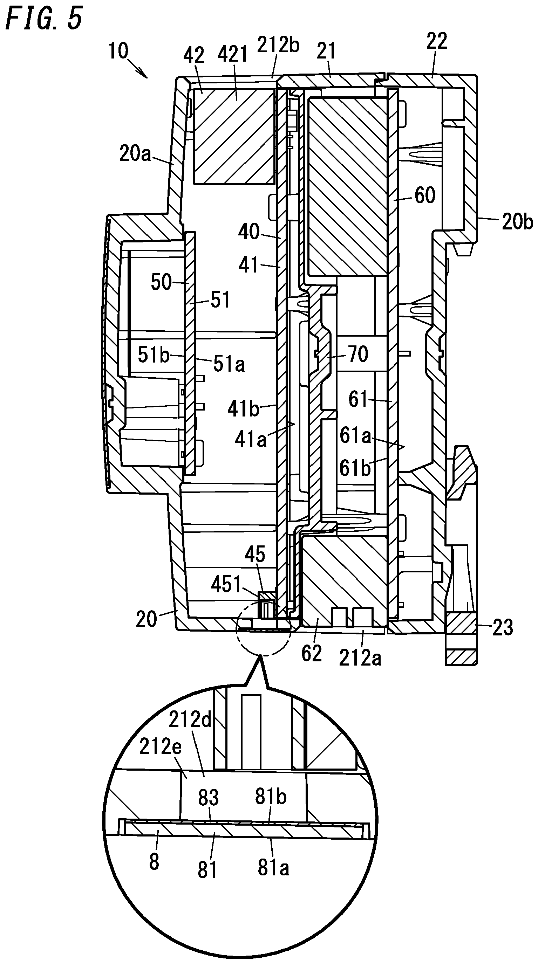

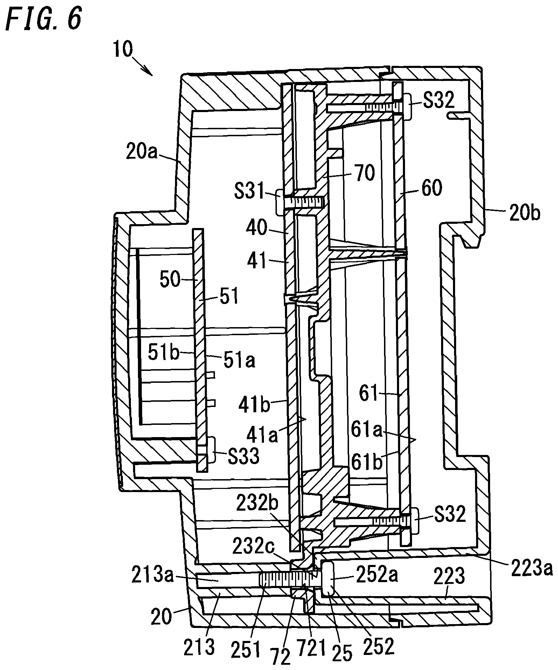

In particular, the measurement device 10 of the present embodiment, as illustrated in FIGS. 5 and 6, includes a measuring unit 40, a communications unit 50, a power supply unit 60 and a housing 20. The measuring unit 40 is configured to generate measuring information relating to a prescribed physical quantity based on the sensing information from the sensor 300. The communications unit 50 is configured to transmit the measuring information generated by the measuring unit 40. The power supply unit 60 is configured to supply electric power to the measuring unit 40 and the communications unit 50. The housing 20 has a first surface 20a and a second surface 20b in a prescribed direction. The housing 20 is configured to house the measuring unit 40, the communications unit 50 and the power supply unit 60. The measuring unit 40 includes a measuring board 41. The communications unit 50 includes a communications board 51, provided separately from the measuring board 41. The power supply unit 60 includes a power supply board 61, provided separately from the measuring board 41 and the communications board 51.

Thus, in the measurement device 10 of the present embodiment, the measuring unit 40, the communications unit 50 and the power supply unit 60 constitute a circuit section of the measurement device 10, and respectively include boards different from one another (the measuring board 41, the communications board 51 and the power supply board 61). Therefore, it can reduce a chance that noise generated at any of the boards of the measuring unit 40, the communications unit 50 and the power supply unit 60 affects the other boards. In particular, the power supply unit 60 tends to generate noise greater than noise generated at the other units, but the measurement device 10 can be expected to reduce the influence by the noise generated at the power supply unit 60 on the measuring unit 40 or the communications unit 50. Accordingly, the measurement device 10 can realize reducing the influence by the noise generated in circuit (the measuring unit 40, the communications unit 50 and the power supply unit 60).

### (1-2) Details

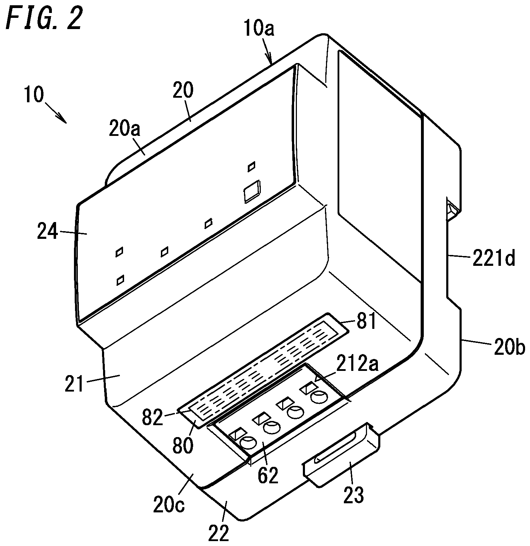

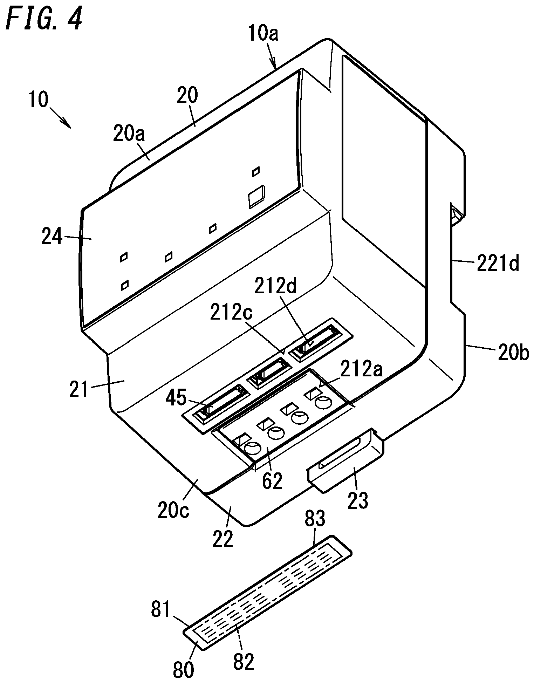

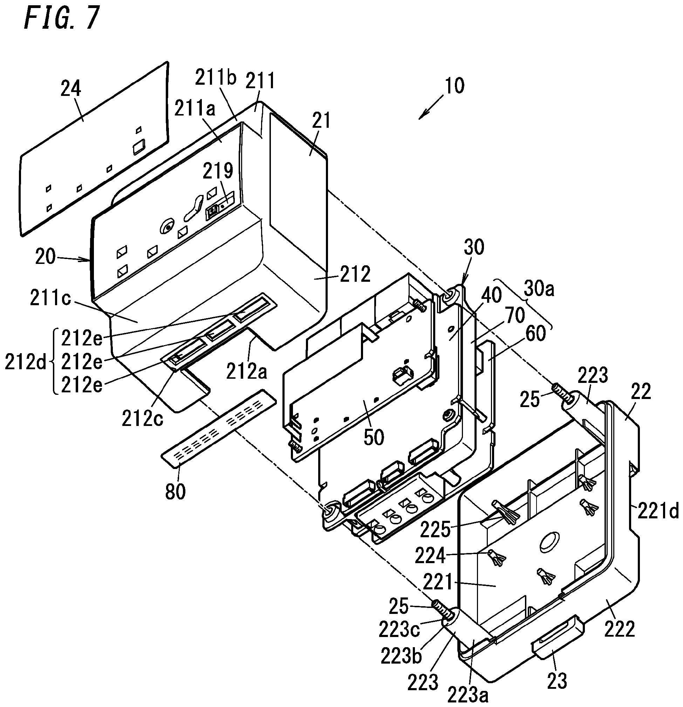

Hereinafter, the measurement device 10 according to the present embodiment will be described in more detail with reference to the drawings (mainly FIGS. 2 to 13). As illustrated in FIGS. 2 to 7, the measurement device 10 includes a housing 20 and a circuit section 30. The housing 20 has a first surface 20a and a second surface 20b that is on the opposite side to the first surface 20a in a prescribed direction and is configured to house the circuit section 30 (refer to FIGS. 5 to 7). In the present embodiment, the prescribed direction is assumed to correspond to forward and backward directions of the housing 20. That is to say, the first surface 20a corresponds to a front surface of the housing 20, and the second surface 20b corresponds to a rear surface of the housing 20. Hereinafter, when the prescribed direction corresponds to the forward and backward directions, the first surface 20a of the housing 20 is referred to as the "front surface 20a" and the second surface 20b of the housing 20 is referred to as the "rear surface 20b" as needed for convenience of explanation. As illustrated in FIGS. 7 to 9, the circuit section 30 includes a measuring unit 40, a communications unit 50, a power supply unit 60 and a support 70. The circuit section 30 and the housing 20 constitute a main body 10a of the measurement device 10. As illustrated in FIGS. 2 and 4, a hiding member 80 is attached to the main body 10a.

### (1-2-1) Circuit Section

As illustrated in FIGS. 7 to 9, the circuit section 30 includes the measuring unit 40, the communications unit 50, the power supply unit 60 and the support 70.

The measuring unit 40 is configured to generate measuring information relating to a prescribed physical quantity based on sensing information (e.g., a measurement value) from a sensor 300 (refer to FIG. 1). In the present embodiment, the sensor 300 is a current sensor. The current sensor is provided for measuring power supplied from an AC power supply 200, power supplied from a power generation apparatus (such as a solar cell, a power storage device, or a fuel cell), or power consumed by a load or the like. In this case, as the prescribed physical quantity, electric power (a unit: W) is assumed. In the present embodiment, the measuring unit 40 generates the measuring information (power measuring information) relating to the prescribed physical quantity (electric power) based on the sensing information (a current value) from the sensor 300.

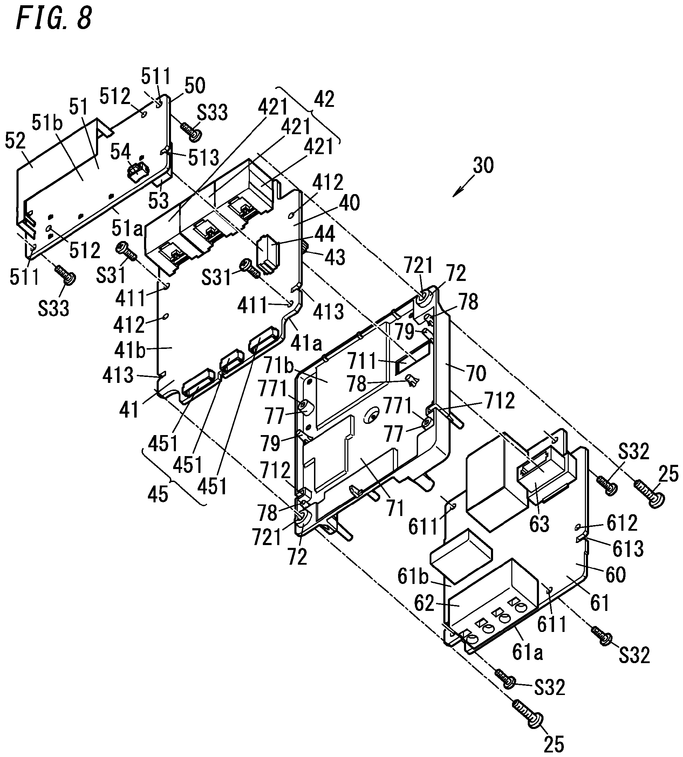

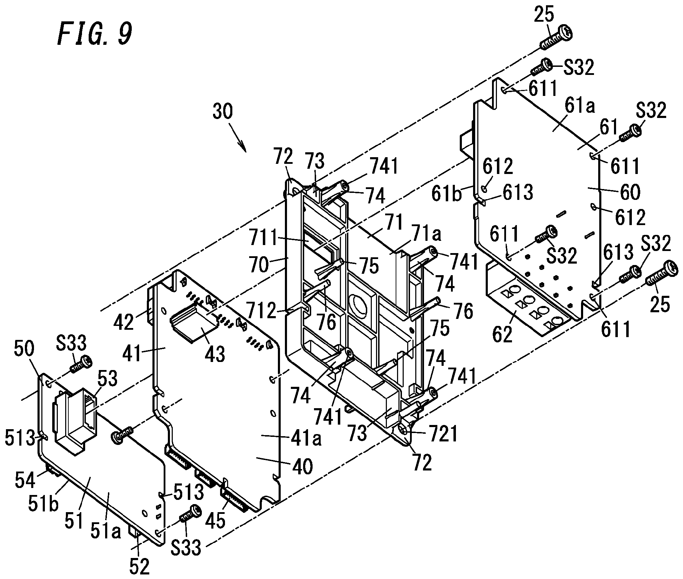

As illustrated in FIGS. 8 and 9, the measuring unit 40 includes a measuring board 41. The measuring board 41 is a board (such as a printed wiring board) where electronic components can be mounted. The measuring board 41 is formed into a rectangular plate shape, and has a first surface 41a and a second surface 41b in a thickness direction thereof. The first surface 41a and the second surface 41b are almost flat surfaces. The first surface 41a is a surface facing the power supply unit 60. Also, the first surface 41a is a surface of the measuring board 41 on the rear surface 20b side of the housing 20. The second surface 41b is a surface facing the communications unit 50. The measuring board 41 further has one or more through holes 411 (two or more in the present embodiment; two in the example of the drawings), one or more positioning recesses 412 (two or more in the present embodiment; two in the example of the drawings), and one or more notches 413 (two or more in the present embodiment; two in the example of the drawings). The through holes 411 are provided for fixing the measuring unit 40 to the support 70 with screws S31. The positioning recesses 412 are provided for positioning the measuring unit 40 with respect to the support 70. In the present embodiment, the positioning recesses 412 are implemented as through holes. The notches 413 are provided in edges of the measuring board 41. The notches 413 are provided for positioning the measuring unit 40 with respect to the housing 20.

The measuring unit 40 is configured by mounting electronic components on the measuring board 41. The measuring unit 40 includes a sensor connecting part 42, a connector 43, a connector (first connector) 44 and an interface part 45. The sensor connecting part 42 is mounted on the measuring board 41 to be electrically connected to the sensor 300 (current sensor). The sensor connecting part 42 includes a jack 421 configured such that a plug of a LAN cable is connected to the jack 421. In the present embodiment, the sensor connecting part 42 includes two or more jacks 421 (three in the example of the drawings). The jacks 421 are mounted on the second surface 41b of the measuring board 41. In particular, the sensor connecting part 42 is mounted at an end part of the measuring board 41. The connector 43 is provided for electrically connecting the measuring unit 40 and the power supply unit 60. The connector 43 is mounted on the first surface 41a of the measuring board 41. The connector 44 is provided for electrically connecting the measuring unit 40 and the communications unit 50. The connector 44 is mounted on the second surface 41b of the measuring board 41. The interface part 45 is provided for at least one of checking or changing an internal state of the electric apparatus (measurement device 10). Examples of the internal state include information (e.g., version of software) relating to software in the electric apparatus (measurement device 10), and setting values such as parameters for calculating the physical quantity from the sensing information. The interface part 45 includes a connector 451 to which a communications cable can be connected. In the present embodiment, the interface part 45 includes two or more connectors 451 (three in the example of the drawings). The connectors 451 are mounted on the second surface 41b of the measuring board 41. In particular, the interface part 45 is mounted at an end part of the measuring board 41. The sensor connecting part 42 and the interface part 45 are respectively disposed at the end parts, which are on the opposite side to each other, of the measuring board 41.

The communications unit 50 is configured to transmit the measuring information generated by the measuring unit 40. In the present embodiment, the communications unit 50 transmits, by radio communication, the measuring information generated by the measuring unit 40. As one example, the communications unit 50 is configured to communicate with a telecommunication device (e.g., a gateway) by radio communication and transmit the measuring information to the telecommunication device. The measuring information (received by the telecommunication device) is transmitted by radio communication or wire communication from the telecommunication device to an information presentation device previously set. The information presentation device is configured to present the measuring information received from the telecommunication device. Accordingly, a user can check the measuring information presented by the information presentation device.

As illustrated in FIGS. 8 and 9, the communications unit 50 includes a communications board 51. The communications board 51 is a board (such as a printed wiring board) where electronic components can be mounted. The communications board 51 is provided separately from the measuring board 41. The communications board 51 is formed into a rectangular plate shape, and has a first surface 51a and a second surface 51b in a thickness direction thereof. The first surface 51a and the second surface 51b are almost flat surfaces. The first surface 51a is a surface facing the measuring unit 40. Also, the first surface 51a is a surface of the communications board 51 on the rear surface 20b side of the housing 20. The second surface 51b is a surface that is on the opposite side to the measuring unit 40. The communications board 51 further has one or more through holes 511 (two or more in the present embodiment; two in the example of the drawings), one or more positioning recesses 512 (two or more in the present embodiment; two in the example of the drawings), and one or more notches 513 (two or more in the present embodiment; two in the example of the drawings). The through holes 511 are provided for fixing the communications unit 50 to the housing 20 with screws S33. The positioning recesses 512 are provided for positioning the communications unit 50 with respect to the housing 20. In the present embodiment, the positioning recesses 512 are implemented as through holes. The notches 513 are provided for positioning the communications unit 50 with respect to the housing 20. The notches 513 are provided in edges of the communications board 51. In particular, the notches 513 are disposed at positions corresponding to the notches 413 of the measuring board 41, of the communications board 51.

The communications unit 50 is configured by mounting electronic components on the communications board 51. The communications unit 50 includes an antenna 52, a connector (second connector) 53 and an operation unit 54. The antenna 52 is provided for radio communication to be performed by the communications unit 50. The antenna 52 is mounted on the second surface 51b of the communications board 51. The connector 53 is mounted on the first surface 51a of the communications board 51. The connector 53 is provided for electrically connecting the measuring unit 40 and the communications unit 50. In particular, the connector (second connector) 53 is configured to be directly connected to the connector (first connector) 44. That is to say, the connector 53 and the connector 44 are mechanically connected to each other, thereby the measuring unit 40 and the communications unit 50 being electrically connected to each other. The operation unit 54 is provided to accept setting for the communication to be performed by the communications unit 50. In the present embodiment, the communications unit 50 is configured to register a destination device for the radio communication by the operation unit 54 being operated. In the present embodiment, the operation unit 54 is implemented as a push switch.

The power supply unit 60 is configured to supply electric power to the measuring unit 40 and the communications unit 50. In the present embodiment, the power supply unit 60 is configured to convert input power into output power with lower voltage than the input power, and output the output power converted. In the present embodiment, the input power is the AC power supplied from the AC power supply 200. Accordingly, the voltage of the input power is evaluated by an effective value. The output power is output as an operating power for the measuring unit 40 and the communications unit 50. The output power is the DC power. Thus, the power supply unit 60 generates the output power (DC power) for operating of the measuring unit 40 and the communications unit 50 based on the input power (AC power) supplied from the AC power supply 200, and then outputs the output power.

As illustrated in FIGS. 8 and 9, the power supply unit 60 includes a power supply board 61. The power supply board 61 is a board (such as a printed wiring board) where electronic components can be mounted. The power supply board 61 is provided separately from the measuring board 41 and the communications board 51. The power supply board 61 is formed into a rectangular plate shape, and has a first surface 61a and a second surface 61b in a thickness direction thereof. The first surface 61a and the second surface 61b are almost flat surfaces. The first surface 61a is a surface of the power supply board 61 on the rear surface 20b side of the housing 20. The second surface 61b is a surface facing the measuring unit 40. The power supply board 61 further has one or more through holes 611 (two or more in the present embodiment; four in the example of the drawings), one or more positioning recesses 612 (two or more in the present embodiment; two in the example of the drawings), and one or more notches 613 (two or more in the present embodiment; two in the example of the drawings). The through holes 611 are provided for fixing the power supply unit 60 to the support 70 with screws S32. The positioning recesses 612 are provided for positioning the power supply unit 60 with respect to the support 70. In the present embodiment, the positioning recesses 612 are implemented as through holes. The notches 613 are provided in edges of the power supply board 61. The notches 613 are provided for positioning the power supply unit 60 with respect to the housing 20.

The power supply unit 60 is configured by mounting electronic components on the power supply board 61. The power supply unit 60 includes a power supply terminal part 62 and a connector 63. The power supply terminal part 62 is mounted on the power supply board 61 to be electrically connected to a power line from an external power supply (AC power supply 200). In the present embodiment, the power supply terminal part 62 is electrically connected to the branch open/close device 120 in the distribution board 100 with the power line. Accordingly, the power supply terminal part 62 is electrically connected to the AC power supply 200. The power supply terminal part 62 is mounted on the second surface 61b of the power supply board 61. In particular, the power supply terminal part 62 is disposed at an end part of the power supply board 61. The connector 63 is provided for electrically connecting the power supply unit 60 and the measuring unit 40. The connector 63 is mounted on the second surface 61b of the power supply board 61. In particular, the connector 63 is configured such that the connector 43 is connected thereto. That is to say, the connector 63 and the connector 43 are mechanically connected to each other, thereby the measuring unit 40 and the power supply unit 60 being electrically connected to each other. Therefore, the power supply unit 60 converts the electric power (input power) obtained from the AC power supply 200 via the power supply terminal part 62 into the output power for operating the measuring unit 40 and the power supply unit 60, and then outputs the output power from the connector 63. The output power from the connector 63 is supplied to the measuring unit 40 via the connector 43, and also supplied to the communications unit 50 via the connector 44 of the measuring unit 40 and the connector 53 of the communications unit 50. Thus, the electric power is supplied from the power supply unit 60 to the measuring unit 40 and the communications unit 50.

The support 70 has electrical insulation. More specifically, the support 70 is a molded article made of a resin material with electrical insulation. The support 70 is disposed between the measuring unit 40 and the power supply unit 60. Accordingly, it can further increase an insulation distance between the measuring unit 40 and the power supply unit 60, compared with that no support 70 is provided. In the present embodiment, the measuring board 41 of the measuring unit 40 and the power supply board 61 of the power supply unit 60 are physically fixed to the support 70. That is to say, the measuring unit 40 and the power supply unit 60 are physically coupled to each other. Thus, the measuring unit 40 and the power supply unit 60 physically coupled constitute a circuit block 30a (refer to FIG. 7) of the circuit section 30. The circuit block 30a is an aggregate of components, which can be handled integrally. The circuit block 30a further includes the support 70. The support 70 is provided to be physically fixed to the housing 20 inside the housing 20. In particular, the support 70 is fixed to the housing 20, using coupling members 25 described later (refer to FIGS. 6, 8 and 9). Accordingly, the circuit block 30a is physically fixed to the housing 20.

As illustrated in FIGS. 8 and 9, the support 70 includes a main body 71, one or more fixing parts 72 (two or more in the present embodiment; two in the example of the drawings), and one or more wall parts 73 (two or more in the present embodiment; two in the example of the drawings). The main body 71 is formed into a rectangular plate shape, and has a first surface 71a and a second surface 71b in a thickness direction thereof. The first surface 71a is a surface facing the power supply unit 60. The first surface 71a is a surface of the main body 71 on the rear surface 20b side of the housing 20. The second surface 71b is a surface facing the measuring unit 40. The main body 71 has a size to cover at least a part through which the input power flows in the power supply board 61. That is to say, the main body 71 functions as a protection part provided to cover at least the part through which the input power flows in the power supply board 61. In the present embodiment, the main body 71 has a connection hole 711. The connection hole 711 is provided for electrically connection between the measuring unit 40 and the power supply unit 60. The connection hole 711 has a size to cause the connector 43 of the measuring unit 40 to pass through the connection hole 711. That is to say, while the support 70 is disposed between the measuring unit 40 and the power supply unit 60, the measuring unit 40 and the power supply unit 60 are electrically connected to each other by the connector 43 and the connector 63 being directly connected to each other through the connection hole 711. The main body 71 includes one or more notches 712 (two or more in the present embodiment; two in the example of the drawings). The notches 712 are provided in edges of the main body 71. The notches 712 are provided for positioning the support 70 with respect to the housing 20. The fixing parts 72 are provided for fixing the support 70 to the housing 20. The fixing parts 72 have holes 721 through which the coupling members 25 are caused to pass, respectively. In the present embodiment, the support 70 includes two fixing parts 72, which are respectively disposed at both corners positioned diagonally, of the main body 71. The wall parts 73 are provided to further increase insulation distances between the coupling members 25 and the measuring unit 40 or the power supply unit 60, compared with that no wall part 73 is provided. In the present embodiment, the wall parts 73 are disposed between the fixing parts 72 and the main body 71. In particular, the wall parts 73 are disposed on the first surface 71a of the main body 71.

As illustrated in FIG. 9, the support 70 further includes one or more fixing protrusions 74 (two or more in the present embodiment; four in the example of the drawings), one or more supporting protrusions 75 (two or more in the present embodiment; two in the example of the drawings), and one or more positioning protrusions 76 (two or more in the present embodiment; two in the example of the drawings). The fixing protrusions 74, supporting protrusions 75 and positioning protrusions 76 are disposed on the first surface 71a of the main body 71. The fixing protrusions 74 are provided for fixing the power supply unit 60 to the support 70. The fixing protrusions 74 are provided in ends thereof with screw holes 741 respectively corresponding to the screws S32. The four fixing protrusions 74 are at positions respectively corresponding to the four through holes 611 in the power supply board 61 of the power supply unit 60. The supporting protrusions 75 function as spacers for keeping constant a distance between the main body 71 and the power supply board 61. The supporting protrusions 75 are disposed to, when the power supply board 61 is fixed to the main body 71, come into contact with the second surface 61b of the power supply board 61 to keep contact the distance between the main body 71 and the power supply board 61. The positioning protrusions 76 are provided for positioning the power supply unit 60 with respect to the support 70. More specifically, the positioning protrusions 76 are respectively fit into the positioning recesses 612 in the power supply board 61 of the power supply unit 60, thereby the power supply unit 60 being positioned with respect to the support 70. The two positioning protrusions 76 are at positions respectively corresponding to the two positioning recesses 612 in the power supply board 61 of the power supply unit 60.

As illustrated in FIG. 8, the support 70 further includes one or more fixing protrusions 77 (two or more in the present embodiment; two in the example of the drawings), one or more supporting protrusions 78 (two or more in the present embodiment; two in the example of the drawings), and one or more positioning protrusions 79 (two or more in the present embodiment; two in the example of the drawings). The fixing protrusions 77, supporting protrusions 78 and positioning protrusions 79 are disposed on the second surface 71b of the main body 71. The fixing protrusions 77 are provided for fixing the measuring unit 40 to the support 70. The fixing protrusions 77 are provided in ends thereof with screw holes 771 respectively corresponding to the screws S31. The two fixing protrusions 77 are at positions respectively corresponding to the two through holes 411 in the measuring board 41 of the measuring unit 40. The supporting protrusions 78 function as spacers for keeping constant a distance between the main body 71 and the measuring board 41. The supporting protrusions 78 are disposed to, when the measuring board 41 is fixed to the main body 71, come into contact with the first surface 41a of the measuring board 41 to keep contact the distance between the main body 71 and the measuring board 41. The positioning protrusions 79 are provided for positioning the measuring unit 40 with respect to the support 70. More specifically, the positioning protrusions 79 are respectively fit into the positioning recesses 412 in the measuring board 41 of the measuring unit 40, thereby the measuring unit 40 being positioned with respect to the support 70. The two positioning protrusions 79 are at positions respectively corresponding to the two positioning recesses 412 in the measuring board 41 of the measuring unit 40.

As illustrated in FIG. 6, the measuring board 41, communications board 51 and power supply board 61 of the circuit section 30 described above are boards provided separately from one another. The communications board 51 is disposed between the front surface 20a of the housing 20 and a set of the measuring board 41 and the power supply board 61. The power supply board 61 is disposed between the rear surface 20b of the housing 20 and a set of the measuring board 41 and the communications board 51. The measuring board 41, communications board 51 and power supply board 61 are arranged in the forward and backward directions of the housing 20. The measuring board 41, communications board 51 and power supply board 61 are disposed in parallel to one another.

### (1-2-2) Housing

As illustrated in FIG. 7, the housing 20 includes a cover 21, a body 22, an attachment part 23, a protection member 24, and one or more coupling members 25 (two or more in the present embodiment; two in the example of the drawings).

The coupling members 25 are members provided for coupling the cover 21 to the body 22. In the present embodiment, the coupling members 25 are screws (e.g., male screws). More specifically, the coupling members 25 each includes a screw part 251 and a head part 252 (refer to FIG. 6). The head part 252 has an end surface 252a that is on the opposite side to the screw part 251, and the end surface 252a has a tool hole into which a tip of a tool is fit. Examples of the shape of the tool hole include a slitting hole, a cross hole, a square hole, a hexagon hole and a specific hole. The specific hole is a hole corresponding to not a common tool such as a Phillips screwdriver or a slotted screwdriver, but a specific tool. Examples of the specific hole include a Tri-Wing hole. In the present embodiment, the coupling members 25 are Tri-Wing screws. The coupling members 25 are made of metal.

The cover 21 and the body 22 of the housing 20 constitute parts housing the circuit section 30. In particular, the cover 21 is a part having the front surface 20a of the housing 20. The body 22 is a part having the rear surface 20b of the housing 20. The cover 21 and the body 22 have electrical insulation. More specifically, the cover 21 and the body 22 are molded articles made of resin materials with electrical insulation.

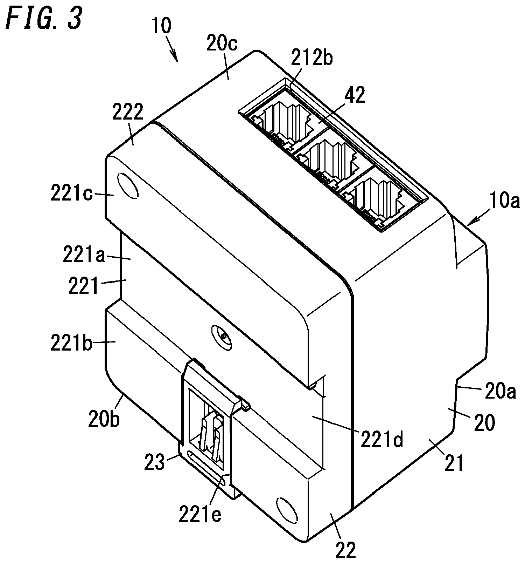

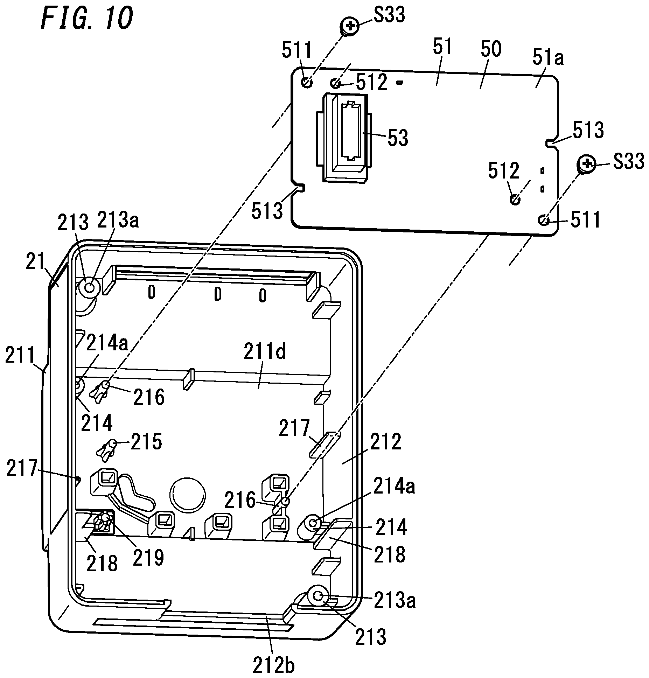

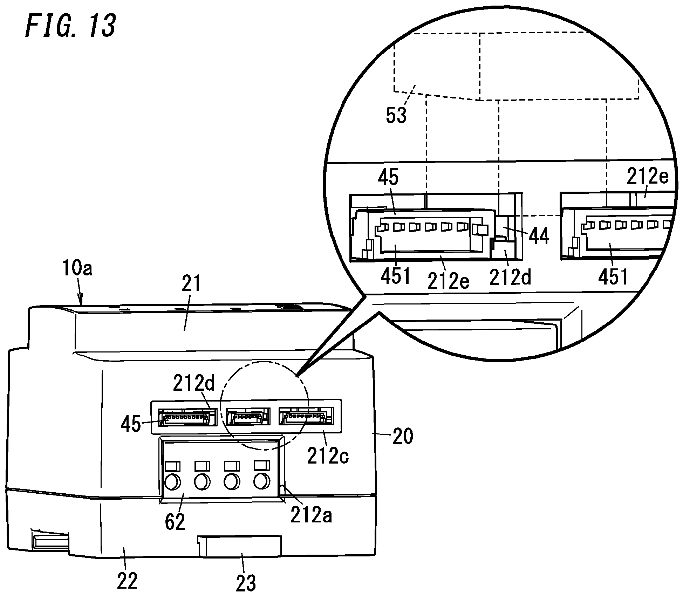

As illustrated in FIGS. 7 and 10, the cover 21 is formed into a box shape with one surface (rear surface) opened. The cover 21 has a front wall part 211 and a side wall part 212. The front wall part 211 has an outer circumference with a rectangular shape. The front wall part 211 is divided to three parts in the longitudinal direction: a central part 211a, a first end part 211b and a second end part 211c. The central part 211a is formed to be protruded forward with respect to the first end part 211b and the second end part 211c such that a housing space 211d is provided in an inner bottom of the cover 21. The housing space 211d is a space provided for mainly housing the communications unit 50. The side wall part 212 is formed to be protruded backward from the outer circumference of the front wall part 211. In the preset embodiment since the front wall part 211 has the outer circumference with the rectangular shape, the side wall part 212 has a rectangular tube shape. The side wall part 212 includes a connection port (first connection port) 212a and a connection port (second connection port) 212b. As illustrated in FIG. 2, the first connection port 212a is provided for exposing the power supply terminal part 62 to the outside. The first connection port 212a is a part corresponding to the second end part 211c, of the side wall part 212. As illustrated in FIG. 3, the second connection port 212b is provided for exposing the sensor connecting part 42 to the outside. The second connection port 212b is a part corresponding to the first end part 211b, of the side wall part 212. The side wall part 212 is provided in the vicinity (the front side in the present embodiment) of the first connection port 212a with a recess 212c. The recess 212c has a rectangular shaped opening. The longitudinal direction of the recess 212c is parallel to the width direction of the cover 21. The recess 212c has a bottom surface in which an opening part 212d is provided. That is to say, the opening part 212d is disposed in the vicinity of the first connection port 212a. The opening part 212d includes one or more openings 212e (two or more in the present embodiment; three in the example of the drawings). The openings 212e are arranged along the longitudinal direction of the recess 212c. The openings 212e each has a rectangular shape. The opening part 212d is provided for exposing the interface part 45 of the circuit section 30 to the outside. More specifically, the openings 212e of the opening part 212d are provided to expose the connectors 451 of the interface part 45, respectively. In the present embodiment, the size of the opening part 212d is not equal to, but greater than the size of the interface part 45. Accordingly, there is a gap between the opening part 212d and the interface part 45, and the inside of the housing 20 can be visually recognized through the gap. More specifically, as illustrated in FIG. 13, the opening part 212d is provided, through which a connection state of the connector (first connector) 44 of the measuring unit 40 and the connector (second connector) 53 of the communications unit 50 is visually recognized.

As illustrated in FIG. 10, the cover 21 further includes one or more first coupling protrusions 213 (two or more in the present embodiment; two in the example of the drawings), one or more fixing protrusions 214 (two or more in the present embodiment; two in the example of the drawings), one or more supporting protrusions 215 (one in the present embodiment), and one or more positioning protrusions 216 (two or more in the present embodiment; two in the example of the drawings). The first coupling protrusions 213, fixing protrusions 214, supporting protrusion 215 and positioning protrusions 216 are disposed on the inner bottom of the cover 21. The first coupling protrusions 213 are provided for coupling the body 22 to the cover 21. The first coupling protrusions 213 are provided in ends thereof with holes 213a corresponding to the coupling members 25, respectively. The holes 213a are screw holes corresponding to the screw parts 251 of the coupling members 25, respectively. The two first coupling protrusions 213 are respectively disposed at both corners positioned diagonally, of the inner bottom of the cover 21. The fixing protrusions 214 are provided for fixing the communications unit 50 to the cover 21 (i.e., the housing 20). The fixing protrusions 214 are provided in ends thereof with screw holes 214a corresponding to the screws S33, respectively. The two fixing protrusions 214 are at positions respectively corresponding to the two through holes 511 in the communications board 51 of the communications unit 50. The supporting protrusion 215 functions as a spacer for keeping constant a distance between the front wall part 211 of the cover 21 and the communications board 51. The supporting protrusion 215 is disposed to, when the communications board 51 is fixed to the cover 21, come into contact with the second surface 51b of the communications board 51 to keep contact the distance between the front wall part 211 of the cover 21 and the communications board 51. The positioning protrusions 216 are provided for positioning the communications unit 50 with respect to the cover 21. More specifically, the positioning protrusions 216 are respectively fit into the positioning recesses 512 in the communications board 51 of the communications unit 50, thereby the communications unit 50 being positioned with respect to the cover 21. The two positioning protrusions 216 are at positions respectively corresponding to the two positioning recesses 512 in the communications board 51 of the communications unit 50.

As illustrated in FIG. 10, the cover 21 further includes one or more positioning pieces 217 (two or more in the present embodiment; two in the example of the drawings), and one or more positioning pieces 218 (two or more in the present embodiment; two in the example of the drawings). The positioning pieces 217 and 218 are provided on an inner side surface of the side wall part 212 of the cover 21. The positioning pieces 217 are provided for positioning the communications unit 50 with respect to the cover 21 (i.e., the housing 20). More specifically, the positioning pieces 217 are respectively fit into the notches 513 in the communications board 51 of the communications unit 50, thereby the communications unit 50 being positioned with respect to the cover 21. The two positioning pieces 217 are at positions respectively corresponding to the two notches 513 in the communications board 51 of the communications unit 50. The positioning pieces 218 are provided for positioning the circuit block 30a of the circuit section 30 with respect to the cover 21 (i.e., the housing 20). More specifically, the positioning pieces 218 are fit into the notches 413 in the measuring board 41 of the measuring unit 40, the notches 613 in the power supply board 61 of the power supply unit 60 and the notches 712 in the main body 71 of the support 70, thereby the circuit block 30a being positioned with respect to the cover 21. The two positioning pieces 218 are at positions respectively corresponding to the two notches 413 in the measuring board 41 of the measuring unit 40, the two notches 613 in the power supply board 61 of the power supply unit 60 and the two notches 712 in the main body 71 of the support 70.

As illustrated in FIG. 10, the cover 21 further includes an operation piece 219. The operation piece 219 is provided for operating the operation unit 54 of the communications unit 50. The operation piece 219 is disposed at the central part 211a of the front wall part 211. The operation piece 219 has flexibility. The operation piece 219 has: a fixed end that is one end of both ends in a longitudinal direction thereof; and a free end that is the other end of both ends in the longitudinal direction and movable in the forward and backward directions with respect to the central part 211a. The operation piece 219 is positioned at the front of the operation unit 54. The operation unit 54 is pressed in response to that the operation piece 219 is pressed.

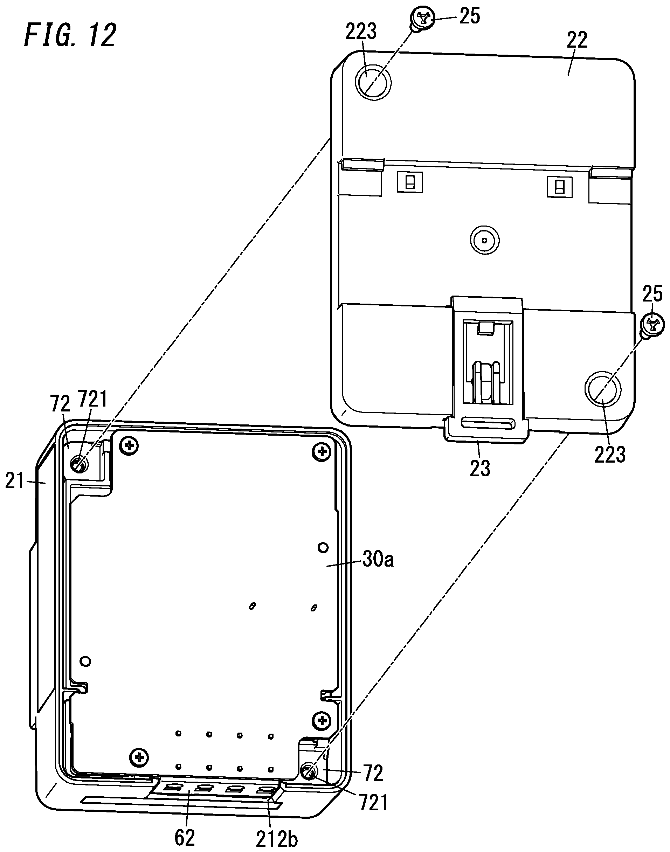

As illustrated in FIGS. 7 and 12, the body 22 has a box shape with one surface (front surface) opened. The body 22 includes a rear wall part 221 and a side wall part 222. The rear wall part 221 has an outer circumference with a rectangular shape. As illustrated in FIG. 3, the rear wall part 221 is divided to three parts in the longitudinal direction: a central part 221a, a first end part 221b and a second end part 221c. The first end part 221b and the second end part 221c are formed to be protruded backward with respect to the central part 221a such that an attachment space 221d is provided in the bottom of the body 22. The attachment space 221d has opened sides in the width direction of the rear wall part 221. The attachment space 221d is a space provided for mainly locating the attachment member 140. The rear wall part 221 further has an attachment recess 221e disposed at a central part in the width direction of the first end part 221b. The attachment recess 221e has opened sides in the longitudinal direction of the rear wall part 221 and is communicated with the attachment space 221d. The side wall part 222 is protruded backward from the outer circumference of the rear wall part 221. In the present embodiment, since the rear wall part 221 has the outer circumference with the rectangular shape, the side wall part 222 has a rectangular tube shape.

As illustrated in FIG. 7, the body 22 further includes one or more second coupling protrusions 223 (two or more in the present embodiment; two in the example of the drawings), and one or more supporting protrusions 224 (two or more in the present embodiment; five in the example of the drawings). The second coupling protrusions 223 and the supporting protrusions 224 are provided on an inner bottom of the body 22 (i.e., the front surface of the rear wall part 221).

The second coupling protrusions 223 are provided for coupling the body 22 to the cover 21. The second coupling protrusions 223 are also provided for fixing the support 70, together with the first coupling protrusions 213. In particular, the support 70 is configured such that the fixing parts 72 are sandwiched by the first coupling protrusions 213 and the second coupling protrusions 223. That is to say, the support 70 is sandwiched by the cover 21 and the body 22 to be fixed therebetween. The two second coupling protrusions 223 are respectively disposed at both corners positioned diagonally, of the inner bottom of the body 22. More specifically, the two second coupling protrusions 223 are at positions respectively corresponding to the two first coupling protrusions 213 of the cover 21. As illustrated in FIG. 6, the second coupling protrusions 223 each includes: a tubular part 223a protruded forward from the inner bottom of the rear wall part 221; and a bottom part 223b disposed at a first end (front end) in an axis direction, of the tubular part 223a. The tubular parts 223a each has a cylindrical shape. The tubular parts 223a each has an inner diameter larger than an outer diameter of the head part 252 of each coupling member 25. The tubular part 223a includes a second end (rear end) in the axis direction, and the second end is opened in an outer bottom of the rear wall part 221. Accordingly, the coupling members 25 can be respectively inserted into the insides of the tubular parts 223a of the second coupling protrusions 223 from the rear of the housing 20. The bottom parts 223b have holes 223c corresponding to the coupling members 25, respectively. Each hole 223c has a size to allow the screw part 251 of the corresponding coupling member 25 to pass therethrough, but not to allow the head part 252 to pass therethrough. The height of each second coupling protrusion 223 is set such that the end surface 252a of the coupling member 25 on the rear surface 20b side of the housing 20 is disposed between the front surface 20a of the housing 20 and the first surface 61a of the power supply board 61 on the rear surface 20b side of the housing 20. In particular, the height of each second coupling protrusion 223 in the present embodiment is set such that the end surface 252a of the coupling member 25 is disposed between the front surface 20a of the housing 20 and the whole of the power supply unit 60. Furthermore, the height of each second coupling protrusion 223 is set such that a distance between the surface (first surface 51a) of the communications board 51 on the rear surface 20b side of the housing 20 and the end surface 252a of the coupling member 25 is longer than a distance between the surface (first surface 61a) of the power supply board 61 on the rear surface 20b side of the housing 20 and the end surface 252a.

The supporting protrusions 224 function as spacers for keeping constant a distance between the rear wall part 221 of the body 22 and the power supply board 61. The supporting protrusions 224 are disposed to, when the power supply board 61 is fixed to the body 22, come into contact with the first surface 61a of the power supply board 61 to keep contact the distance between the rear wall part 221 of the body 22 and the power supply board 61.

The attachment part 23 is provided for attaching the measurement device 10 to the attachment member 140. The attachment part 23 is attached to the attachment recess 221e in the rear wall part 221 of the body 22 to be movable along the longitudinal direction of the rear wall part 221. In particular, the attachment part 23 can be moved between: a first position where the attachment part 23 is not protruded into the attachment space 221d from the attachment recess 221e; and a second position where the attachment part 23 is protruded into the attachment space 221d from the attachment recess 221e. That is to say, while the attachment part 23 is at the first position, the attachment member 140 is located in the attachment space 221d, and then the attachment part 23 is moved from the first position to the second position, thereby the attachment member 140 being sandwiched between the body 22 and the attachment part 23. Therefore, the measurement device 10 is attached to the attachment member 140. Thus, the housing 20 is provided on the rear surface 20b with the attachment part 23 for attaching the measurement device 10 to the attachment member 140.

The protection member 24 is attached to the cover 21. More specifically, the protection member 24 has a rectangular sheet shape. The protection member 24 may be made of a resin material. The protection member 24 is attached to the front surface of the central part 211a of the front wall part 211 of the cover 21 so as to cover the whole of the central part 211a. The protection member 24 is attached with an adhesive or the like to the central part 211a of the front wall part 211 of the cover 21. The protection member 24 has flexibility to an extent that the operation piece 219 can be operated via the protection member 24.

As described above, the housing 20 is configured to house the circuit section 30. As illustrated in FIG. 2, the housing 20 is configured to cause the sensor connecting part 42 of the measuring unit 40 of the circuit section 30 to be exposed. Also as illustrated in FIG. 3, the housing 20 is configured to cause the interface part 45 of the measuring unit 40 of the circuit section 30 and the power supply terminal part 62 of the power supply unit 60 of the circuit section 30 to be exposed. In particular, the housing 20 causes the power supply terminal part 62 and the interface part 45 to be exposed in the same surface. In the present embodiment, the power supply terminal part 62 and the interface part 45 are exposed in a side surface 20c of the housing 20. In particular, the power supply terminal part 62 and the interface part 45 are exposed in a specific part of the side surface 20c of the housing 20. The specific part is at a position to be hidden in a state where the measurement device 10 is installed. The cabinet 130 of the distribution board 100 causes only the central part 211a of the front wall part 211 of the housing 20 of the measurement device 10 to be exposed. Accordingly, the side surface 20c of the housing 20 is hidden by the cabinet 130. In this case, the specific part may correspond to the whole of the side surface 20c of the housing 20.

As illustrated in FIG. 6, regarding the housing 20, the end surfaces of 252a of the coupling members 25 are disposed between the front surface 20a of the housing 20 and the surface (first surface 61a) of the power supply board 61 on the rear surface 20b side of the housing 20. In particular, the end surfaces of 252a of the coupling members 25 are disposed between the front surface 20a of the housing 20 and the whole of the power supply unit 60. The thickness direction of the power supply board 61 is parallel to a direction (i.e., the forward and backward directions of the housing 20) in which the body 22 and the cover 21 are coupled to each other by the coupling members 25. Also in the measurement device 10, the measuring unit 40 is disposed between the end surfaces 252a of the coupling members 25 and the front surface 20a of the housing 20. In particular, the surface (first surface 41a) of the measuring board 41 on the rear surface 20b side of the housing 20 is disposed between the end surface 252a of the coupling member 25 and the front surface 20a of the housing 20. The thickness direction of the measuring board 41 is parallel to the direction (i.e., the forward and backward directions of the housing 20) in which the body 22 and the cover 21 are coupled to each other by the coupling members 25. Furthermore, in the measurement device 10, as illustrated in FIG. 6, the end surfaces of 252a of the coupling members 25 are disposed between the communications unit 50 and the rear surface 20b of the housing 20. In particular, the end surfaces of 252a of the coupling members 25 are disposed between the rear surface 20b of the housing 20 and the surface (first surface 51a) of the communications board 51 on the rear surface 20b side of the housing 20. The thickness direction of the communications board 51 is parallel to the direction (i.e., the forward and backward directions of the housing 20) in which the body 22 and the cover 21 are coupled to each other by the coupling members 25. The distance between the surface (first surface 51a) of the communications board 51 on the rear surface 20b side of the housing 20 and the end surface 252a of each coupling member 25 is longer than the distance between the surface (first surface 61a) of the power supply board 61 on the rear surface 20b side of the housing 20 and the end surface 252a.

### (1-2-3) Hiding Member

The hiding member 80 is detachably attached to the main body 10a of the measurement device 10 as the electric apparatus (refer to FIG. 2). In the present embodiment, as illustrated in FIGS. 4 and 5, the hiding member 80 is attached to the housing 20 to cover the opening part 212d of the housing 20. That is to say, the hiding member 80 is a member provided for hiding the interface part 45 such that the interface part 45 exposed from the housing 20 can't be seen.

More specifically, the hiding member 80 includes a cover part 81, an indicating part 82 and an attachment part 83. The cover part 81 is detachably attached to the housing 20 so as to cover the opening part 212d (the interface part 45). The cover part 81 has a rectangular sheet shape with a size to be fit in the recess 212c of the cover 21 of the housing 20. The cover part 81 has a first surface 81a and a second surface 81b in a thickness direction thereof. The cover part 81 is attached to the housing 20 such that the second surface 81b faces the opening part 212d (the interface part 45) side. The cover part 81 has the shape to be fit into the recess 212c. That is to say, the cover part 81 comprehensively covers all the openings 212e of the opening part 212d, thereby the whole of the opening part 212d (the interface part 45) being covered. Examples of the material for the cover part 81 include a resin material and a metal material. The indicating part 82 is disposed at the cover part 81 on the opposite side to the interface part 45. That is to say, the indicating part 82 is disposed on the first surface 81a of the cover part 81. The indicating part 82 is provided for indicating information (internal information) relating to the internal state of the electric apparatus (the measurement device 10). The internal information may be selected from: check information relating to the internal state, checked through the interface part 45; and change information relating to the internal state, changed through the interface part 45. The check information may include the present information (e.g., the present version of the software) relating to the software in the electric apparatus (the measurement device 10), or the present setting value such as parameters for calculating the physical quantity from the sensing information. The change information may include the information after changing (e.g., the version of the software after changing) relating to the software in the electric apparatus (the measurement device 10), or the setting value after changing, such as parameters for calculating the physical quantity from the sensing information. The change information may include the history of information (e.g., the version of the software) relating to the software in the electric apparatus (the measurement device 10), or the history of the setting value such as parameters for calculating the physical quantity from the sensing information. In the present embodiment, the indicating part 82 includes a unique region that indicates the internal information. The unique region may indicate the internal information with a character(s), a color(s) or a shape(s). For example, the unique region may be a character string indicating the version of the software, or a color (or a shape) corresponding to the version of the software. In the present embodiment, the unique region is assumed to be the character string indicating the version of the software. The attachment part 83 is provided for detachably attaching the cover part 81 to the housing 20. In the present embodiment, the attachment part 83 includes an adhesive. More specifically, the attachment part 83 is implemented as an adhesive layer configured such that the cover part 81 can be peeled from the housing 20. The attachment part 83 is disposed at the cover part 81 on the opening part 212d (the interface part 45) side. That is to say, the attachment part 83 is disposed on the second surface 81b of the cover part 81.

The hiding member 80 is removed from the housing 20, when the interface part 45 is used. Accordingly, the worker can perform a prescribed processing, using the interface part 45. After that, the worker attaches to the housing 20 the hiding member 80 corresponding to the contents of the processing performed using the interface part 45. In the present embodiment, the hiding member 80 is assumed to be replaced, when the processing is performed using the interface part 45. For example, when the version of the software in the measurement device 10 is Version 1.0, the hiding member 80 with the indicating part 82 showing Version 1.0 is attached to the housing 20 of the measurement device 10. When changing the software in the measurement device 10 from Version 1.0 to Version 2.0, the worker first removes the hiding member 80 from the housing 20 to use the interface part 45. The worker then connects a communications cable to the interface part 45 and accesses the measurement device 10 from a management terminal to upgrade the version of the software. After that, the worker removes the communications cable from the interface part 45. The worker then attaches to the housing 20 the hiding member 80 with the indicating part 82 showing that the version of the software in the measurement device 10 is Version 2.0 such that the interface part 45 is covered with the hiding member 80. Therefore, the user can check the information relating to the internal state of the measurement device 10 by the appearance of the measurement device 10.

### (1-3) Assembling Method

Hereinafter, the assembling method for the measurement device 10 will be described with reference to FIGS. 10 to 13.

As illustrated in FIG. 10, the communications unit 50 is first attached to the cover 21. The communications unit 50 is disposed in the housing space 211d of the cover 21 with the second surface 51b of the communications board 51 facing the front wall part 211 of the cover 21. At this time, the two positioning pieces 217 of the cover 21 are respectively fit into the two notches 513 of the communications board 51. Also, the two positioning protrusions 216 of the cover 21 are respectively fit into the two positioning recesses 512 of the communications board 51. Accordingly, the communications unit 50 is positioned with respect to the cover 21. Then the screws S33 are coupled into the screw holes 214a of the fixing protrusions 214 of the cover 21 via the through holes 511 of the communications board 51.

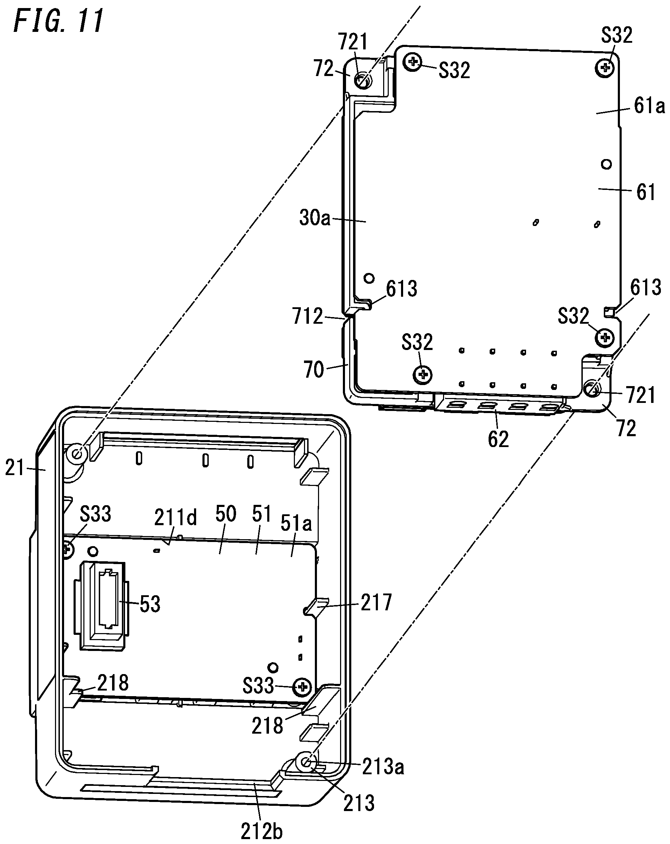

Next, as illustrated in FIG. 11, the circuit block 30a is housed in the cover 21. The circuit block 30a is prepared by previously coupling the measuring unit 40, the power supply unit 60 and the support 70 to one another. The circuit block 30a is housed in the cover 21 with the measuring unit 40 facing the communications unit 50. Accordingly, the connector 44 of the measuring unit 40 is connected to the connector 53 of the communications unit 50. Also, the two positioning pieces 218 of the cover 21 are fit into the two notches 413 of the measuring board 41, the two notches 712 of the main body 71 and the two notches 613 of the power supply board 61, respectively. Accordingly, the circuit block 30a is positioned with respect to the cover 21. The holes 213a of the first coupling protrusions 213 of the cover 21 are exposed from the holes 721 of the fixing parts 72 of the support 70 of the circuit block 30a.

Next, as illustrated in FIG. 12, the body 22 is coupled to the cover 21. The body 22 is first disposed to cover the opening in the rear surface of the cover 21. The coupling members 25 are then inserted into the inside of the second coupling protrusions 223 of the body 22. The screw parts 251 of the coupling members 25 are coupled into the holes 213a of the first coupling protrusions 213 of the cover 21 via the holes 223c of the bottom parts 223b of the second coupling protrusions 223 and the holes 721 of the fixing parts 72 of the support 70. Accordingly, the cover 21 and the body 22 are coupled to each other with the coupling members 25. Also, the support 70 is physically fixed to the housing 20 with the coupling members 25. That is to say, the circuit block 30a is also physically fixed to the housing 20.

After the cover 21 and the body 22 are coupled, as illustrated in FIG. 13, the person visually checks the connection state of the connector (first connector) 44 of the measuring unit 40 and the connector (second connector) 53 of the communications unit 50 through the opening part 212d of the housing 20.

Lastly, the hiding member 80 is attached to the housing 20. More specifically, the cover part 81 of the hiding member 80 is fit into the recess 212c with the second surface 81b facing the opening part 212d (the interface part 45). The cover part 81 is detachably attached to the housing 20 with the attachment part 83 of the hiding member 80. Since the indicating part 82 is disposed at the cover part 81 on the opposite side to the opening part 212d (the interface part 45), the person can check the internal information of the measurement device 10 through the indicating part 82.

### (2) Variations

The exemplary embodiment described above is only an exemplary one of various embodiments of the present disclosure and should not be construed as limiting. The exemplary embodiment described above may be readily modified in various manners depending on a design choice or any other factor, as long as the purpose of the present disclosure can be attained. Hereinafter, variations of the exemplary embodiment described above will be listed.

As one variation, the shapes of the components of the measurement device 10 are not necessarily limited to those in the exemplary embodiment described above but may be modified as appropriate depending on a design or specification requirements of the measurement device 10. For example, the housing 20 may be formed into a box shape with a circle surface or a polygonal surface, as whole. Also, the number of the components of the measurement device 10 may be modified as appropriate depending on use of the components. For example, the number of the screws S31 to S33 may be modified as appropriate.

As one variation, the circuit section 30 may further include a board(s) other than the measuring board 41, the communications board 51 and the power supply board 61. That is to say, the circuit section 30 may further include another circuit element(s) in addition to the measuring unit 40, the communications unit 50 and the power supply unit 60. The order in which the measuring board 41, the communications board 51 and the power supply board 61 are arranged is not limited in particular. As one example, the communications board 51 is not necessarily disposed between the front surface 20a of the housing 20 and a set of the measuring board 41 and the power supply board 61. Also, the power supply board 61 is not necessarily disposed between the rear surface 20b of the housing 20 and a set of the measuring board 41 and the communications board 51. Furthermore, the measuring board 41, the communications board 51 and the power supply board 61 are not necessarily arranged in the forward and backward directions of the housing 20. Also, the measuring board 41, the communications board 51 and the power supply board 61 may be disposed in non-parallel to one another.

As one variation, the measuring unit 40 may be configured to correspond to a sensor(s) other than the current sensor. That is to say, the sensor 300 is not limited to the current sensor. For example, the sensor 300 may be one selected from the group consisting of a temperature sensor, a humidity sensor, a flow sensor for fluid such as gas or liquid, an electromagnetic wave sensor, a motion sensor, an image sensor, an ultrasonic sensor and the like. The processing contents of the measuring unit 40 may be set depending on a type of the sensor 300. The measuring unit 40 does not necessarily include a single measuring board 41 but may include two or more measuring boards 41. The shape of the measuring board 41 may be also modified as appropriate. The through holes 411, the positioning recesses 412 and the notches 413 of the measuring board 41 are optional elements. Also, the jack 421, to which the plug of the LAN cable is connected, of the sensor connecting part 42 is optional. The sensor connecting part 42 may include a dedicated connector, or a connector corresponding to the other type of plug. The connectors 43 and 44 are not needed to be directly connected to the corresponding connectors 63 and 53 but may be indirectly connected thereto via an electric wire or the like. The interface part 45 is not necessarily provided at the measuring board 41 but may be provided at the communications board 51 or the power supply board 61. In short, the interface part 45 may be provided at any one of those boards of the circuit section 30. In this case, the interface part 45 is preferably disposed at an end part of any one of those boards. The interface part 45 can be easily exposed from the housing 20 to the outside by the interface part 45 being disposed at the end part. The positions of the sensor connecting part 42, the connectors 43, 44 and the interface part 45 on the measuring board 41 are not limited in particular. The interface part 45 is not always necessary to be provided. If no interface part 45 is provided, the hiding member 80 may be also omitted.

As one variation, the communications unit 50 may transmit, by wire communication, the measuring information generated by the measuring unit 40. When the communications unit 50 performs the wire communication, the antenna 52 and the operation unit 54 are not required. The communications unit 50 does not necessarily include a single communications board 51 but may include two or more communications boards 51. The shape of the communications board 51 may be also modified as appropriate. The through holes 511, the positioning recesses 512 and the notches 513 of the communications board 51 are optional elements. The antenna 52 is not limited to a member separately from the communications board 51 but may be printed on the communications board 51. The operation unit 54 is not necessarily mounted on the communications board 51 but may be mounted on the measuring board 41 or the power supply board 61. In short, the operation unit 54 may be mounted on a specific board, as one selected from the group consisting of the measuring board 41, the communications board 51 and the power supply board 61. The specific board is preferably physically fixed to the housing 20. The operation unit 54 may be used for different purpose depending on whether the specific board is the measuring board 41, the communications board 51 or the power supply board 61. For example, when the specific board is the measuring board 41, the operation unit 54 may be provided to accept setting for the measurement to be performed by the measuring unit 40. When the specific board is the power supply board 61, the operation unit 54 may be provided to accept setting for the power supplying to be performed by the power supply unit 60.

As one variation, the power supply unit 60 may supply to the measuring unit 40 and the communications unit 50 the power received not from the external power supply such as the AC power supply 200 but from a battery built in the measurement device 10. The power supply unit 60 does not necessarily include a single power supply board 61 but may include two or more power supply boards 61. The shape of the power supply board 61 may be also modified as appropriate. The through holes 611, the positioning recesses 612 and the notches 613 of the power supply boards 61 are optional elements. The power supply unit 60 may be electrically connected to the communications unit 50 not via the measuring unit 40.

As one variation, the support 70 may include at least the main body 71. For example, the support 70 is not necessarily directly fixed to the housing 20. The shape of the main body 71 may be also modified as appropriate. The connection hole 711, the fixing protrusions 74, the supporting protrusions 75, the positioning protrusions 76, the fixing protrusions 77, the supporting protrusions 78 and the positioning protrusions 79 of the main body 71 are optional elements. Also, the support 70 is not essential.

As one variation, the housing 20 does not necessarily include the attachment part 23 and the protection member 24. The prescribed direction may correspond to rightward and leftward directions of the housing 20, and the first surface 20a and the second surface 20b may be both side surfaces of the housing 20. The configurations of the cover 21 and the body 22 may be modified as appropriate, depending on the configuration of the circuit section 30. For example, the cover 21 and the body 22 may include a part through which the circuit section 30 is partially exposed, as needed. On the other hand, if it is not needed that the circuit section 30 is partially exposed, the part for partially exposing the circuit section 30 may be omitted. Also, a part to be used for fixing or positioning of the circuit section 30 (e.g., the fixing protrusions 214 or the supporting protrusions 215), of the cover 21 and the body 22, may be omitted as appropriate.

As one variation, the end surface 252a of the coupling member 25 of the housing 20 is not necessarily disposed between the front surface 20a of the housing 20 and the surface (first surface 61a) of the power supply board 61 on the rear surface 20b side of the housing 20. The measuring unit 40 is not necessarily disposed between the front surface 20a of the housing 20 and the end surface 252a of the coupling member 25. In particular, the surface (first surface 41a) of the measuring board 41 on the rear surface 20a side of the housing 20 is not necessarily disposed between the front surface 20a of the housing 20 and the end surface 252a of the coupling member 25. Furthermore, the end surface 252a of the coupling member 25 is not necessarily disposed between the rear surface 20b of the housing 20 and the communications unit 50. In particular, the end surface 252a of the coupling member 25 is not necessarily disposed between the rear surface 20b of the housing 20 and the surface (first surface 51a) of the communications board 51 on the rear surface 20b side of the housing 20. Also, the distance between the surface (first surface 51a) of the communications board 51 on the rear surface 20b side of the housing 20 and the end surface 252a of the coupling member 25 is not necessarily longer than a distance between the surface (first surface 61a) of the power supply board 61 on the rear surface 20b side of the housing 20 and the end surface 252a of the coupling member 25.

As one variation, the coupling members 25 are not limited to the screws (male screws) but may be the other fastening tools such as bolts and nuts. The coupling members 25 may be omitted.

As one variation, the hiding member 80 may include at least the cover part 81 and the indicating part 82. The shape of the cover part 81 may be modified as appropriate. The indicating part 82 may include a margin for making an entry of the internal information. In this case, the entry of the internal information (check information or change information) can be made in the indicating part 82 in response to processing performed using the interface part 45 (processing checking or changing the internal state). The indicating part 82 may include both of the margin and the unique region. The indicating part 82 may be configured such that the contents thereof can be changed, and in this case, the replacement of the hiding member 80 itself is no longer required. The attachment part 83 may have a mechanical structure to be physically coupled to the housing 20. For example, the attachment part 83 may have a mechanical structure capable of screwing the cover part 81 to the housing 20, or fitting the cover part 81 and the housing 20 to each other. The attachment part 83 may have both of the mechanical structure and an adhesive. In short, the attachment part 83 may have at least one of the adhesive or the mechanical structure to be physically coupled to the housing 20.

### (3) Aspects

As can be seen from the foregoing embodiment and variations, the present disclosure includes the following aspects. The following aspects are referenced with reference numerals in parentheses only to clearly indicate the correspondence with the foregoing embodiment.

A first aspect is a measurement device (10), and includes a measuring unit (40), a communications unit (50), a power supply unit (60) and a housing (20). The measuring unit (40) is configured to generate measuring information relating to a prescribed physical quantity based on sensing information from a sensor (300). The communications unit (50) is configured to transmit the measuring information generated by the measuring unit (40). The power supply unit (60) is configured to supply electric power to the measuring unit (40) and the communications unit (50). The housing (20) has a first surface (20a) and a second surface (20b) in a prescribed direction. The housing (20) is configured to house the measuring unit (40), the communications unit (50) and the power supply unit (60). The measuring unit (40) includes a measuring board (41). The communications unit (50) includes a communications board (51), provided separately from the measuring board (41). The power supply unit (60) includes a power supply board (61), provided separately from the measuring board (41) and the communications board (51). According to this aspect, the measurement device (10) can realize reducing influence by noise generated in circuit.

A second aspect is the measurement device (10) based on the first aspect. In the second aspect, the communications board (51) is disposed between the first surface (20a) of the housing (20) and a set of the measuring board (41) and the power supply board (61). According to this aspect, the measurement device (10) can realize reducing influence by noise generated in circuit.

A third aspect is the measurement device (10) based on the first or second aspect. In the third aspect, the power supply board (61) is disposed between the second surface (20b) of the housing (20) and a set of the measuring board (41) and the communications board (51). According to this aspect, the measurement device (10) can realize reducing influence by noise generated in circuit.

A fourth aspect is the measurement device (10) based on any one of the first to third aspects. In the fourth aspect, the measuring board (41), the communications board (51) and the power supply board (61) are arranged in the prescribed direction. According to this aspect, the measurement device (10) can realize reducing influence by noise generated in circuit.

A fifth aspect is the measurement device (10) based on any one of the first to fourth aspects. In the fifth aspect, the measuring board (41), the communications board (51) and the power supply board (61) are disposed in parallel to one another. According to this aspect, the measurement device (10) can realize reducing influence by noise generated in circuit.

A sixth aspect is the measurement device (10) based on any one of the first to fifth aspects. In the sixth aspect, the housing (20) is provided on the second surface (20b) with an attachment part (23) for attaching the measurement device (10) to an attachment member (140). According to this aspect, the measurement device (10) can realize reducing influence by noise generated in circuit.

A seventh aspect is the measurement device (10) based on any one of the first to sixth aspects. In the seventh aspect, the measurement device (10) further includes a support (70) having electrical insulation and provided to be physically fixed to the housing (20) inside the housing (20). The measuring board (41) and the power supply board (61) are physically fixed to the support (70). According to this aspect, the measurement device (10) can realize reducing influence by noise generated in circuit.

An eighth aspect is the measurement device (10) based on the seventh aspect. In the eighth aspect, the support (70) is disposed between the measuring board (41) and the power supply board (61). According to this aspect, the measurement device (10) can realize reducing influence by noise generated between the measuring board (41) and the power supply board (61).

A ninth aspect is the measurement device (10) based on the eighth aspect. In the ninth aspect, the power supply unit (60) is configured to convert input power into output power with lower voltage than the input power, and output the output power converted. The support (70) includes a protection part (71) provided to cover at least a part through which the input power flows in the power supply board (61). According to this aspect, the measurement device (10) can realize reducing influence by noise generated at the power supply board (61).

A tenth aspect is the measurement device (10) based on any one of the seventh to ninth aspects. In the tenth aspect, at least one of the measuring board (41) or the power supply board (61) includes one or more positioning recesses (412, 612). The support (70) includes one or more positioning protrusions (76, 79) to be fit into the one or more positioning recesses (412, 612). According to this aspect, the measurement device (10) can realize easily fixing the measuring board (41) or the power supply board (61) to the support (70).

An eleventh aspect is the measurement device (10) based on any one of the first to tenth aspects. In the eleventh aspect, the measurement device (10) further includes an operation unit (54) mounted on a specific board, as one selected from the group consisting of the measuring board (41), the communications board (51) and the power supply board (61). The specific board is physically fixed to the housing (20). According to this aspect, the measurement device (10) can reduce a chance that the position of the specific board is shifted by operation to the operation unit (54).

A twelfth aspect is the measurement device (10) based on the eleventh aspect. In the twelfth aspect, the specific board is the communications board (51). The operation unit (54) is provided to accept setting for communication to be performed by the communications unit (50). According to this aspect, the user can easily set the communication for the measurement device (10).

A thirteenth aspect is the measurement device (10) based on any one of the first to twelfth aspects. In the thirteenth aspect, the measuring unit (40) further includes a first connector (44) mounted on the measuring board (41). The communications unit (50) further includes a second connector (53) mounted on the communications board (51) to be directly connected to the first connector (44). The housing (20) has an opening part (212d) through which a connection state of the first connector (44) and the second connector (53) is visually recognized. According to this aspect, the user can easily check the connection state of the first connector (44) and the second connector (53).

A fourteenth aspect is the measurement device (10) based on any one of the first to thirteenth aspects. In the fourteenth aspect, the sensor (300) is a current sensor. The measuring unit (40) further includes a sensor connecting part (42) mounted on the measuring board (41), to which the sensor (300) is electrically connected. The housing (20) includes a connection port (212b) through which the sensor connecting part (42) is exposed. The sensor connecting part (42) includes a jack (421) configured such that a plug of a LAN cable is connected to the jack (421). According to this aspect, the user can easily connect the current sensor (300) to the measurement device (10).

A fifteenth aspect is a measurement device (10), and includes: a measuring unit (40) configured to generate measuring information relating to electric power based on sensing information from a sensor (300); and a housing (20) configured to house the measuring unit (40). The measuring unit (40) includes a measuring board (41). The measuring unit (40) further includes a sensor connecting part (42) mounted on the measuring board (41), to which the sensor (300) is electrically connected. The housing (20) includes a connection port (212b) through which the sensor connecting part (42) is exposed. The sensor connecting part (42) includes a jack (421) configured such that a plug of a LAN cable is connected to the jack (421). According to this aspect, the user can easily connect the current sensor (300) to the measurement device (10).

### Reference Signs List

- 10: Measurement Device (Electric Apparatus)
- 20: Housing
- 20a: First Surface (Front Surface)
- 20b: Second Surface (Rear Surface)
- 212b: Connection Port
- 212d: Opening Part
- 23: Attachment Part
- 40: Measuring Unit
- 41: Measuring Board
- 42: Sensor Connecting Part
- 421: Jack
- 44: Connector (First Connector)
- 412: Positioning Recess
- 50: Communications Unit
- 51: Communications Board
- 53: Connector (Second Connector)
- 54: Operation Unit
- 60: Power Supply Unit
- 61: Power Supply Board
- 612: Positioning Recess
- 70: Support
- 71: Main Body (Protection Part)
- 76, 79: Positioning Protrusion
- 140: Attachment Member
- 300: Sensor

## Claims

1. A measurement device, comprising:
a measuring unit configured to generate measuring information relating to a prescribed physical quantity based on sensing information from a sensor;
a communications unit configured to transmit the measuring information generated by the measuring unit;
a power supply unit configured to supply electric power to the measuring unit and the communications unit; and
a housing having a first surface and a second surface in a prescribed direction, the housing being configured to house the measuring unit, the communications unit and the power supply unit,
the measuring unit including a measuring board,
the communications unit including a communications board, provided separately from the measuring board, and
the power supply unit including a power supply board, provided separately from the measuring board and the communications board.

2. The measurement device of claim 1, wherein
the communications board is disposed between the first surface of the housing and a set of the measuring board and the power supply board.

3. The measurement device of claim 1 or 2, wherein
the power supply board is disposed between the second surface of the housing and a set of the measuring board and the communications board.

4. The measurement device of any one of claims 1 to 3, wherein
the measuring board, the communications board and the power supply board are arranged in the prescribed direction of the housing.

5. The measurement device of any one of claims 1 to 4, wherein
the measuring board, the communications board and the power supply board are disposed in parallel to one another.

6. The measurement device of any one of claims 1 to 5, wherein
the housing is provided on the second surface with an attachment part for attaching the measurement device to an attachment member.

7. The measurement device of any one of claims 1 to 6, further comprising a support having electrical insulation, and provided to be physically fixed to the housing inside the housing, wherein
the measuring board and the power supply board are physically fixed to the support.

8. The measurement device of claim 7, wherein
the support is disposed between the measuring board and the power supply board.

9. The measurement device of claim 8, wherein
the power supply unit is configured to convert input power into output power with lower voltage than the input power, and output the output power converted, and
the support includes a protection part provided to cover at least a part through which the input power flows in the power supply board.

10. The measurement device of any one of claims 7 to 9, wherein
at least one of the measuring board or the power supply board includes one or more positioning recesses, and
the support includes one or more positioning protrusions to be fit into the one or more positioning recesses.

11. The measurement device of any one of claims 1 to 10, further comprising an operation unit mounted on a specific board, as one selected from the group consisting of the measuring board, the communications board and the power supply board, wherein
the specific board is physically fixed to the housing.

12. The measurement device of claim 11, wherein
the specific board is the communications board, and
the operation unit is provided to accept setting for communication to be performed by the communications unit.

13. The measurement device of any one of claims 1 to 12, wherein
the measuring unit further includes a first connector mounted on the measuring board,
the communications unit further includes a second connector mounted on the communications board to be directly connected to the first connector, and
the housing has an opening part through which a connection state of the first connector and the second connector is visually recognized.

14. The measurement device of any one of claims 1 to 13, wherein
the sensor is a current sensor,
the measuring unit further includes a sensor connecting part mounted on the measuring board, to which the sensor is electrically connected,
the housing includes a connection port through which the sensor connecting part is exposed, and
the sensor connecting part includes a jack configured such that a plug of a LAN cable is connected to the jack.
